# EUROPEAN PATENT APPLICATION

(11) **EP 4 099 033 A1**
(43) Date of publication of application: **07.12.2022**
(21) Application number: 21177435.1
(22) Date of filing: 02.06.2021
(51) Int. Cl.: G01R 31/308

(54) **LAYER ARRANGEMENT AND METHOD FOR TESTING A NUMBER OF TUNABLE RADIO FREQUENCY TRANSMISSION ELEMENTS**

(71) Applicant: ALCAN Systems GmbH, 64293 Darmstadt (DE)
(72) Inventor: AYLUCTARHAN, Muhammed, 64285 Darmstadt (DE); MEHMOOD, Arshad, 64283 Darmstadt (DE); JIN, Hyung Nam, 64297 Darmstadt (DE)
(74) Representative: Habermann Intellectual Property Partnerschaft von Patentanwälten mbB

(57) **Abstract**

A layer arrangement (1) for a phased array antenna comprises phase shifting units (4) that are arranged on or between at least two stacked dielectric layers (5, 6) with a layer of tunable dielectric material (12) sandwiched between the at least two stacked dielectric layers (5, 6). Each phase shifting unit (4) comprises at least one transmission line (3) with phase shifting capabilities that is electrically conductively connected with bias lines (10, 11) to at least one biasing circuit. At least one dielectric layer (10, 11) is made from an optically transparent material, and at least an overlapping section of the bias lines (10, 11) of each of the phase shifting units (4) is made from an optically transparent and electroconductive material. The tunable dielectric material is selected from a group of materials that affect the transmission or reflection of light that illuminates the tunable dielectric material depending on the respective tuning state of the tunable dielectric material. A method for testing this layer arrangement (1) comprises a testing step during which the layer arrangement (1) is illuminated by light, during which a predetermined electric bias potential is applied to at least some of the phase shifting units (4), and during which the light emission from the layer arrangement (1) depending on the applied bias potential is detected, and whereby the detected light emission is compared with a light emission that is expected for bias lines (10, 11) in proper working conditions.

## Description

### Technical Field

The invention relates to a method for testing a number of tunable radio frequency transmission elements that are integrated into a layer arrangement, whereby the layer arrangement comprises the phase shifting units that are arranged on or between at least two stacked dielectric layers with a layer of tunable dielectric material sandwiched between the at least two stacked dielectric layers, with each tunable radio frequency transmission element comprising at least one transmission line with tunable capabilities that is electrically conductively connected with bias lines to at least one biasing circuit.

### Background of the invention

Phased array antennas usually comprise a large number of radiation units that must emit electromagnetic radiation with a preset phase shift between the electromagnetic radiation that is emitted from different radiation units. If the phase shift for all radiation units is preset in a suitable manner, the direction of maximum intensity of the electromagnetic radiation that is emitted from the phased array antenna can be specified and changed e.g. according to the position of a sender and a receiver of electromagnetic radiation.

Similarly, if the phased array antenna is used for receiving electromagnetic radiation and for creating a signal that is a superposition of electromagnetic radiation that is received from all radiation units, a direction of maximum sensitivity of reception can be specified and changed, e.g. also according to the position of a sender and a receiver of electromagnetic radiation.

Usually, phased array antennas suitable for emission and reception of radio waves comprise several thousands of radiation units that are arranged on an antenna panel and that are connected to a control unit that controls the radio waves that are emitted or received from the several thousands of radiation units. Each radiation unit is connected to the control unit via a phase shifting device that allows for presetting an individual phase shift of the electromagnetic radiation that is emitted or received with the respective radiation unit. For many applications, the phase shifting units are integrated into a layer arrangement comprising at least two stacked dielectric layers with at least one transmission line with phase shifting capabilities and with a layer of a tunable dielectric material sandwiched between the adjacent two stacked dielectric layers. By applying an electrical field to the tunable dielectric material next to the transmission line, the dielectric properties of the tunable dielectric material can be specified and amended, which will affect the phase shift that is created by the transmission line of the phase shifting unit. The electrical field that is applied to the tunable dielectric material can be preset by applying a bias voltage to bias electrodes that are arranged at the two stacked dielectric layers on both sides of the tunable dielectric material in a manner opposite to each other and overlapping each other in a direction that is perpendicular to each of the two stacked dielectric layers. Usually, overlapping sections of the transmission lines on both dielectric layers are part of the bias electrodes, whereby the bias voltage is applied via electrically conducting bias lines to the transmission lines. Such phase shifting devices with transmission lines and a tunable dielectric material that can be affected by an electrical field that is preset by a bias voltage that is applied via bias lines are described e.g. in EP 2 761 693 B1 or EP 3 609 018 A1.

Proper working conditions of such a phased array antenna requires proper functionality of all subparts, including the control unit, the phase shifting units and the bias lines to which the required bias voltage for each of the phase shifting units can be applied. After manufacturing of a phased array antenna, testing the proper working conditions of the phase shifting units and the bias lines for the respective phase shifting units is burdensome. Usually, such testing requires the application of many different bias voltages to all of the phase shifting units and measuring and evaluating the spatial distribution of the radiation emission that has been performed with the respective application of different bias voltages to the phase shifting devices. Even after measuring and evaluating many different bias voltage patterns that are applied to the phased array antenna, some errors or impairment of the bias lines and the corresponding bias voltages that are applied to the respective phase shifting units are difficult to detect or cannot be detected at all.

There are other devices known that comprise tunable radio frequency transmission elements like e.g. phase shifting elements or transmission lines with tunable capabilities. The capabilities in question can be electrical characteristics that affect the signal transmission. The tuning of the capabilities can be performed by e.g. applying a bias voltage to the transmission line or to electrodes that are part of the transmission line or arranged close to the transmission line. Verifying and confirming proper working conditions of such tunable radio frequency transmission elements can be cumbersome and usually requires time and manual labor, in particular if a device comprises a large number of such tunable radio frequency transmission elements, like e.g. a phased array antenna comprising several thousands of phase shifting units.

Thus, it is considered an objective of the present invention to provide for a method for testing a number of tunable radio frequency transmission elements that requires only small efforts and time, but allows for easy detection of any errors or impairment of the bias lines and of the bias voltage that can be applied with the respective bias lines.

### Summary of the invention

The invention thus relates to a method as described above, whereby at least one dielectric layer is made from an optically transparent material, in that at least an overlapping section of the bias lines of each of the tunable radio frequency transmission elements is made from an optically transparent and electroconductive material, and in that the tunable dielectric material is selected from a group of materials that affect the transmission or reflection of light that illuminates the tunable dielectric material depending on the respective tuning state of the tunable dielectric material, the method comprising a testing step during which the layer arrangement is illuminated by light, during which a predetermined electric bias potential is applied to at least some of the tunable radio frequency transmission elements, and during which the light emission from the layer arrangement depending on the applied bias potential is detected, and whereby the detected light emission is compared with a light emission that is expected for bias lines in proper working conditions. Thus, there is no need for measuring the spatial radiation emission pattern that is created during application of a testing pattern of many different bias voltages to the respective tunable radio frequency transmission elements and in particular to phase shifting units of the phased array antenna. The testing of some or all bias voltages that are applied to the tunable radio frequency transmission elements can be performed by optical measurements of the light emission from the layer arrangement during the application of a predetermined electric bias potential to the phase shifting units. There are many known electrically conducting materials that can be used for manufacturing of transmission lines and bias lines that are optically transparent for visible light or for infrared or ultraviolet light that is transmitted through the electrically conducting materials. For many applications, indium tin oxide that is also labeled ITO can be used as optically transparent electrode material for manufacturing the bias lines which allows for performing optical measurements of the impact that the application of a bias voltage imposes on the tunable dielectric material and thus on the phase shifting unit. Other optical transparent and electrically conducting materials are also well-known and available as well as suited for manufacturing bias lines in such an arrangement. A material is considered to be optical transparent if the intensity of a light beam that propagates through a layer of the material is reduced by less than 75 %, preferably less than 50 % and most preferably less than 25 % of the irradiation intensity, whereby the layer of the material is sufficiently thick enough for the layer to be operated as electrically conducting material with electrically conducting properties similar to ITO.

Optical measurement of the bias voltage that creates the electrical field that affects the tunable dielectric material and thus affects the transmission characteristics of a transmission line, e.g. the phase shift that is created with the respective phase shifting unit, can be performed by taking a picture of the bias lines that are illuminated by light. Depending on the configuration of the tunable radio frequency transmission element and the illumination of the tunable radio frequency transmission element with light, the light intensity that is transmitted through the tunable dielectric material and thus that can be measured by a camera or some other suitable optical measurement device is brighter or more subdued if the bias voltage applied to the tunable dielectric materials is higher or lower. Thus, by taking a picture showing all tunable radio frequency transmission elements during a test allows for easy identification of individual deviations of one or some of the tunable radio frequency transmission elements from the preset testing pattern, as the light intensity of the respective tunable radio frequency transmission elements does not match the light intensity that corresponds to the bias voltage that has been applied to the respective bias lines and tunable radio frequency transmission elements.

It is possible to determine in advance the light emission that can be detected with the test equipment for all possible values of the bias voltage that can be applied to the bias lines and the corresponding tunable radio frequency transmission elements for testing purposes or during operation of the corresponding device. The light emission that has been detected and measured in advance with properly working bias lines and tunable radio frequency transmission elements then equals the expected light emission to be detected when performing the testing method with a number of bias lines and tunable radio frequency transmission elements with still unknown working conditions. As a result, testing the working conditions of the complete device does not require performing many different bias voltages and corresponding measurements and evaluations of radio frequency transmission characteristics, or e.g. radiation emission patters of phased array antennas, but can be performed by application of a single testing pattern of bias voltages to the bias lines and by taking a single optical measurement of light emission from the tunable radio frequency transmission elements.

Thus, even simply visually monitoring or inspecting the light emission of light after traversing at least once the tunable radio frequency transmission elements of a device allows for detecting improper working conditions of single tunable radio frequency transmission elements within a large number of tunable radio frequency transmission elements.

The method according to the invention can be advantageously used for testing several aspects and potential reasons for malfunctions of a device. The connectivity and resistance of bias lines can be tested. The correct bonding and working condition of chips can be tested. Furthermore, also the working conditions of various electronic components as well as of software that is used for operating the device can be tested. Thus, e.g. the addressing, correct mapping and precise application of signal transmissions and bias voltages to each phase shifting unit of a phased array antenna can be verified without any need for measuring the resulting signal emission from the phased array antenna or for connecting measurement devices to each phase shifting unit or radiation element of the phased array antenna.

Even though a visual inspection of light emission during testing cycles is possible, more quantitative light detection and light emission measurements are possible and might result in more precise testing results. According to an advantageous aspect of the invention, the light emission is detected by a light recording device and subsequently evaluated by an evaluation device. A digital camera or an optical scanning device can be used as light recording device. The evaluation of the light emission that has been recorded with such a digital device can be performed with a commercially available computer or with a smart phone device, provided a suitable evaluation program can be run on the respective device. The results of the testing can be evaluated and displayed without any significant time delay. Thus, the testing that is required for evaluation of proper working conditions of the phased array antenna can be performed within a short period of time and with very cost-effective testing equipment. Furthermore, such light emission detection by digital cameras or optical scanning means can be performed automatically, i.e. without any intervention by a user. The method can also be performed as an additional step during or after manufacturing of the corresponding device or electronic component. By integrating the required testing equipment like e.g. a control unit for operating the device for testing purposes, a light source and light detecting means into a manufacturing plant for these devices, a fully automated performance and evaluation of the testing method is possible.

In yet another embodiment of the invention, all of the at least two stacked dielectric layers are made from an optically transparent material, and during the testing step the layer arrangement is illuminated from a first side of the layer arrangement and the light transmitted through the layer arrangement is detected at a second side of the layer arrangement that is opposing the first side. Thus, the two stacked dielectric layers are illuminated e.g. from a backside, and a picture of the light emission that is transmitted through the layer arrangement can be taken from the frontside of the two stacked dielectric layers. The transmission of light through the tunable dielectric material that is sandwiched by the two dielectric layers depends on the electrical field that is applied by a bias voltage between the bias lines. The more bias voltage that is applied to the bias lines, the more or the less light is transmitted through the tunable dielectric material. By consequence, the corresponding image of the bias lines shows brighter or more subdued regions that correspond to the bias lines.

It is also possible to illuminate the two stacked dielectric layers with light coming from one side of the stacked layer, and to measure the light that is reflected from the stacked layer. In order to provide advantageous conditions for such a measurement of reflected light, one of the two dielectric layers are made of an optically transparent material like e.g. glass, whereas the other of the two dielectric layers is made of an optically non-transparent material and preferably of a light reflecting material. The light illuminating device and the optical measurement device are arranged at the side of the optically transparent dielectric layer. Thus, the light from the light illuminating device traverses the optically transparent layer and the tunable dielectric material and is reflected by the light reflecting dielectric layer, thus traversing again the tunable dielectric material and the optically transparent dielectric layer before being captured by the optical measurement device.

It is a further option to arrange a polarizer within the optical path of the light that will be either visually monitored or detected with an optical measurement device. The transmission of light through the tunable dielectric material usually leads to a more or less pronounced polarization of the transmitted light. The effects on the tunable dielectric material during the test operation can often be determined more easily and accurately with the aid of a polarizer.

According to an advantageous aspect of the invention, during the testing step an identical bias potential is applied to the at least some of the phase shifting units. All phase shifting units with the same bias potential should be visible with the same light intensity. Thus, any deviation of the expected same light intensity can be interpreted as a corresponding deviation of the bias voltage that is applied to the respective bias lines and the corresponding phase shifting unit. Deviations of light intensity can be easily detected by viewing a picture that shows the simultaneous optical measurement of many tunable radio frequency transmission elements.

In order to allow for an automated evaluation of the optical measurement of the bias voltage that is applied to a corresponding tunable radio frequency transmission element, e.g. a phase shifting unit, the intensity of the detected light emission is measured. Such a measurement of the light intensity can be performed within a short period of time and with commercially available software and hardware. Depending on the quality of the optical measurement, deviations of less than 1 % from the preset bias voltage can be detected without need for costly testing equipment. Thus, a very precise testing of the phased array antenna is possible within a very short period of time, which significantly reduces the total costs for manufacturing and testing of a phased array antenna. It is also possible to calculate parameters and to generate correction tables that allow for a correction of bias voltages that are applied during operation of the device comprising one or more tunable radio frequency transmission elements, e.g. a phased array antenna, which allows for subsequent correction of some defects or impairment of the phased array antenna caused by improper manufacturing of the phased array antenna.

It is possible to sequentially apply a predetermined bias potential to each of the tunable radio frequency transmission elements during the testing step. Thus, each tunable radio frequency transmission elements can be measured and evaluated separately during the testing step. However, according to another embodiment of the invention, during the testing step the predetermined bias potential is applied to the at least some of the tunable radio frequency transmission elements at the same time. With respect to this testing method, the meaning of the same time shall not be limited to an infinitesimal small instant in time, but also comprise a small duration of time that allows for presetting operation conditions during the testing method, e.g. the time that is required for modifying the bias voltages of all phase shifting units that is applied to the respective phase shifting unit. If a picture is taken of the light emission from several phase shifting units, the preset change of bias voltage shall be completed and each phase shifting unit shall be operated with the preset operating condition at the time of taking the picture. For most applications and devices, the required duration of time will be significantly less than one second.

Thus, the time that is required for testing all of the tunable radio frequency transmission elements can be significantly reduced. Preferably, a predetermined bias potential is applied to all of the tunable radio frequency transmission elements at the same time, and a single image of the light emission from all of the tunable radio frequency transmission elements is taken for subsequent evaluation of the corresponding bias voltage that is applied to each of the tunable radio frequency transmission elements.

If a more individual measuring of optical light emission of some or all of the tunable radio frequency transmission elements is deemed appropriate or favorable, it is also possible to apply the predetermined bias potential to the at least some of the tunable radio frequency transmission elements in a predetermined sequence one after another during the testing step. Thus, the corresponding response of each of the tunable radio frequency transmission elements to the application of the bias potential can be recorded and evaluated individually.

In order to provide for even more precise results and a more thorough testing of each of the tunable radio frequency transmission elements, it is optionally possible to detect a time difference between the application of a variation of the bias potential to a tunable radio frequency transmission elements and the resulting variation of the light emission during the testing step. The time difference between a preset change of the bias voltage that is applied to a tunable radio frequency transmission elements and the resulting change of optical properties of the tunable dielectric material between the bias lines provides additional information about either proper working conditions or possible defects and flaws of the control and operation of the bias potential that is applied to the tunable radio frequency transmission elements. For example, the time delay between a similar change of the bias voltage and the resulting change of optical properties should be identical for identical phase shifting units and respective bias lines within the phased array antenna. If there is a significant difference in response times for identical phase shifting units or bias lines, that cannot be explained e.g. by the design or mode of operation of the respective phase shifting units and bias lines, such a difference can indicate a possible flaw, even though after some time the optical properties of the respective phase shifting unit or the corresponding bias lines become identical to the optical properties of well-functioning phase shifting units and bias lines.

According to yet another aspect of the invention, at least a section of the transmission line of at least some of the tunable radio frequency transmission elements is made from an optically transparent material, and in that during the testing step the light emission from this section of the transmission line of at least some of the tunable radio frequency transmission elements is detected. Thus, it is possible to include at least a section of the transmission lines of some or all tunable radio frequency transmission elements into the testing method based on optical verification of proper working conditions. The light emission coming from the optically transparent section of the transmission line can be easily detected and the light intensity measured, which enables a simple and reliable function test of the transmission line and the corresponding tunable radio frequency transmission element. The optically transparent section of the transmission line can be manufactured e.g. from indium tin oxide or of any other suitable material.

It is also possible to add an additional electrically conductive and optically transparent testing line that overlaps with a bias line and that is not connected with a bias voltage source, but with the transmission line. Thus, the bias voltage that is applied to the bias lines and to the transmission line should result in an identical bias voltage between the testing line and the overlapping bias line. If there is a defect not within the bias lines, but within the transmission line of a tunable radio frequency transmission element, the electric field between the testing line and the overlapping bias line should deviate from the electric field between the two bias lines.

The method according to the invention as described above is especially well suited for testing phase shifting units and in particular for testing phased array antennas that comprise a large number of phase shifting units and radiation elements that must be operated in a precisely coordinated manner.

The invention also relates to a layer arrangement for use within a phased array antenna, whereby the layer arrangement comprises a number of phase shifting units that are arranged on or between at least two stacked dielectric layers with a layer of tunable dielectric material sandwiched between the at least two stacked dielectric layers, with each phase shifting unit comprising at least one transmission line with phase shifting capabilities that is electrically conductively connected with bias lines to at least one biasing circuit.

Such layer arrangements usually comprise a large number of phase shifting units that are connected to a biasing circuit and that are controlled by a control unit. Proper testing all of the bias lines and proper working conditions of the bias lines and the corresponding phase shifting units is burdensome and usually requires testing time and costly test equipment.

Thus, it is considered a further objective of the present invention to provide for a layer arrangement that allows for performing a reliable testing method in a short time and with cost-effective testing equipment.

There, the invention also relates to a layer arrangement as described above, whereby at least one dielectric layer of the two stacked dielectric layers is made from an optically transparent material, whereby at least a part of the bias lines of each of the phase shifting units is made from an optically transparent and electroconductive material, and in that the tunable dielectric material is selected from a group of materials that affect the transmission or reflection of light that illuminates the tunable dielectric material depending on the respective tuning state of the tunable dielectric material. By performing the testing method as described above, the light emission of the optically transparent bias lines can be detected, and by evaluating the detected light emission properties, proper working conditions can be verified. A very quick and simple mode of detection can be a visual inspection of the layer arrangement by a testing person during the application of a preset bias voltage to the bias lines. If e.g. the same bias voltage is applied to similar bias lines of several phase shifting units, but the optical properties of the light emission differs, this can be due to defects or flaws within the bias lines or the corresponding phase shifting units.

In order to facilitate the detection and evaluation of light emission during the testing of the bias lines, it is optionally possible that the overlapping section of the bias lines of each of the phase shifting units comprise a testing area with a width of the testing area larger than the width of the bias lines outside of the testing area. The testing area can be of rectangular or circular or oval shape. The size of the testing area can be large enough to allow for a quick visual inspection by a testing person. It is also possible to provide for a testing area that is large enough to allow for light intensity detection and measurements with intensity values that are clearly above any statistical noise of even small or very cost-effective testing equipment.

According to another embodiment of the invention, at least a section of the transmission line of at least some of the phase shifting units is made from an optically transparent material. Thus, the optical measurement and testing of proper working conditions is not limited to the function of the bias lines, but may also include the working conditions of the transmission lines of some or all of the phase shifting units.

### Brief description of the drawings

The present invention will be more fully understood, and further features will become apparent, when reference is made to the following detailed description and the accompanying drawings. The drawings are merely representative and are not intended to limit the scope of the claims. In fact, those of ordinary skill in the art may appreciate upon reading the following specification and viewing the present drawings that various modifications and variations can be made thereto without deviating from the innovative concepts of the invention. Like parts depicted in the drawings are referred to by the same reference numerals.

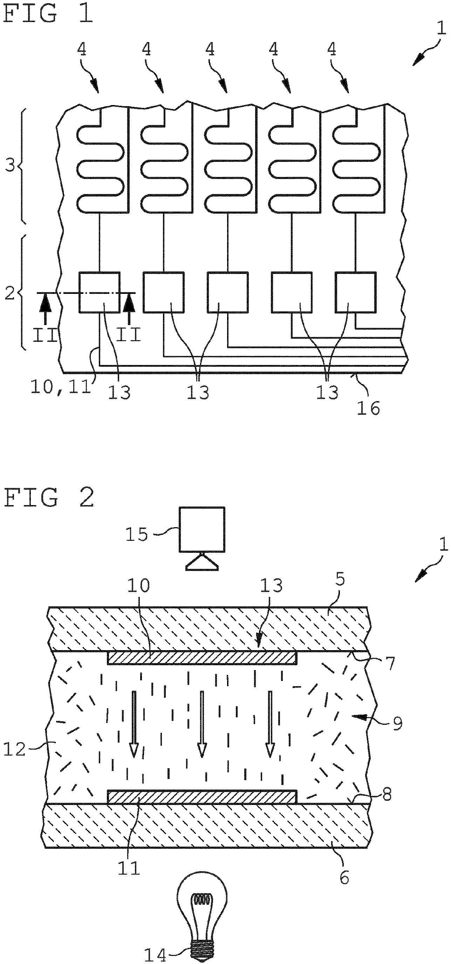

Figure 1 illustrates a schematic top view of a layer arrangement with phase shifting units that are arranged on or between at least two stacked dielectric layers with a layer of tunable dielectric material sandwiched between the at least two stacked dielectric layers, with each phase shifting unit comprising at least one transmission line with phase shifting capabilities that is electrically conductively connected with bias lines to at least one biasing circuit,
Figure 2 illustrates a sectional view of a bias line of a phase shifting unit along the line II-II in Figure 1 together with a schematic representation of an illumination device and an optical recording device used for performing the testing method according to the invention,

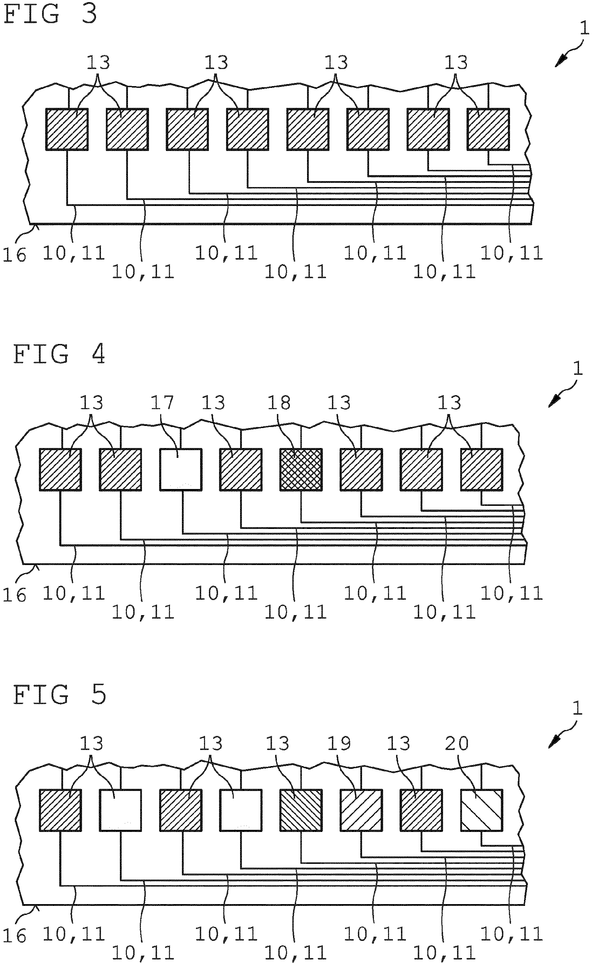

Figure 3 illustrates a schematic representation of the optical properties detected during the testing method of several bias lines which are in proper working condition,
Figure 4 illustrates a schematic representation of the optical properties detected during the testing method of several bias lines, whereby an identical bias voltage has been applied to all bias lines, but two bias lines show deviating optical properties indicating a malfunctioning of said two bias lines, and
Figure 5 illustrates a schematic representation of the optical properties detected during the testing method of several bias lines, whereby a sequence of alternating bias voltages is applied to adjacent bias lines, but two bias lines show deviating optical properties indicating a malfunctioning of said two bias lines.

### Detailed description of the invention

Figure 1 illustrates a top view on a layer arrangement 1 according to the invention, and Figure 2 illustrates a sectional view of a small region of the layer arrangement 1 shown in Figure 1, whereby the small region shown in Figure 2 is limited to a cross-section of a single bias line 2 that connects a transmission line 3 of a phase shifting unit 4. The layer arrangement 1 comprises two stacked dielectric layers 5, 6 made of glass or of another optically transparent dielectric material. The two dielectric layers 5, 6 are arranged parallel and at a distance towards each other. Each dielectric layer 5, 6 comprises a surface 7, 8 that is facing the surface 8, 7 of the other dielectric layer 6, 5, and both surfaces 7, 8 limit a volume 9 in between the two dielectric layers 5, 6. Two overlapping sections of two bias lines 10, 11 are arranged at the two surfaces 7, 8 facing towards each other. The overlapping sections of the two bias lines 10, 11 are made of an electrically conducting, but optically transparent material like e.g. indium tin oxide.

The volume 9 in between the two stacked dielectric layers 5, 6 is filled with a tunable dielectric material 12, which can be e.g. a tunable liquid crystal material with dielectric properties that depend on an electrical field that is applied to the tunable liquid crystal material. By changing the magnitude of the electrical field, the dielectric and optical properties of the tunable liquid crystal material can be affected and varied. In Figure 2, the alignment of molecules of the tunable dielectric material 12 is predetermined by an electrical field that is created by application of a bias voltage between the two bias lines 10, 11, resulting in a predominantly random alignment of the molecules outside of a region between the overlapping sections of the two bias lines 10, 11, and further resulting in a predominantly unified alignment of the molecules within the region between the overlapping sections of the two bias lines 10, 11.

The two bias lines 10, 11 shown in Figure 1 comprise a testing area 13 with a width of the testing area 13 larger than the width of the bias lines 10, 11 outside of the testing area 13. The sectional view of Figure 2 shows a cross-section of the testing area 13 of the bias lines 10, 11 that are connected to the transmission line 3 of a phase shifting unit 4. In Figure 1, a small region of a layer arrangement 1 of a phased array antenna comprising only five phase shifting units 4 is shown, whereby the phased array antenna comprises several thousand phase shifting units 4.

During the execution of the testing method according to the invention, an illumination device 14 is arranged at one side of the layer arrangement 1, which is shown in Figure 1 as being below the layer arrangement 1. At another side of the layer arrangement 1 opposite to the illumination device 14, there is an optical image recording device 15 that is capable of recording an image of the light emission from the layer arrangement 1, i.e. of the light that is emitted from the illumination device 14 and transmitted through the layer arrangement 1. For a qualitative verification of the working condition of the layer arrangement 1, a testing person can visually inspect the light emission from the layer arrangement 1 during the execution of the testing method. For a more elaborated and quantitative verification of the working condition of the layer arrangement 1, the optical image recording device 15 can be a digital camera or a charge-coupled device that allows for a precise measurement of spatial distribution of light intensity.

The testing method comprises a testing step, during which a predetermined electric bias potential is applied to the bias lines 10, 11 of the phase shifting units 4, and the light emission from the layer arrangement 1 is detected with the optical image recording device 15. Thus, if the predetermined electric bias potential is simultaneously applied to many or all of the phase shifting units 4, and if the light emission of many or all of the phase shifting units 4 is simultaneously detected and evaluated, it is possible to test and to verify the proper working condition of many or all of the phase shifting units within a single moment and at the same time.

Figure 3 shows an image of the light emission of eight testing areas 13 of overlapping bias lines 10, 11 arranged along a line parallel to a border 16 of the layer arrangement 1. In order to test the working condition of the bias lines 10, 11, an identical bias voltage is applied to all of the testing areas 13. The image of the light emission of all testing areas 13 show eight regions with identical light emission, i.e. with equal size and intensity of light emission, whereby each region of light emission within the image is related to the corresponding testing area 13. Thus, all bias lines 10, 11 are functioning and in proper working condition.

Figure 4 shows an image of the light emission of another eight testing areas 13 of overlapping bias lines 10, 11 arranged next to the bias lines 10, 11 shown in Figure 3. In this Figure 3, the light emission of the third testing area 17 and the fifth testing area 18 when counted from the left side deviates from the light emission of all other testing areas 13 of the bias lines 10, 11, indicating a defect or impairment of the respective third and fifth bias lines 10, 11 that results in improper working conditions of the respective phase shifting units 4.

Figure 5 shows an image of the light emission of another eight testing areas 13 of overlapping bias lines 10, 11 also arranged along the border 16 of the layer arrangement 1. In order to measure a time dependent response time of the bias lines 10, 11 to changing bias voltages that are applied to the respective bias lines 10, 11, a sequence of alternating bias voltages is applied to the testing areas 13, whereby always the next but one testing area 13 is subjected to a large bias voltage, and each adjacent testing area 13 is simultaneously subjected to a zero bias voltage. Thus, always the next but one testing area 13 should show a bright light emission, whereas each adjacent testing area 13 should be relatively dark within the recorded image of the light emission of the layer arrangement 1. However, as can be seen in Figure 5, the sixth testing area 19 and the eighth testing area 20 when counted from the left side deviate from the light emission of all other testing areas 13 of the bias lines 10, 11, each indicating a defect or impairment, even though the intensity of the light emission recorded for the sixth testing region 19 is identical to the two adjacent testing regions 13, but should be zero due to the alternating setting of the bias voltages.

## Claims

1. Method for testing a number of tunable radio frequency transmission elements (4) that are integrated into a layer arrangement (1), whereby the layer arrangement (1) comprises the tunable radio frequency transmission elements (4) that are arranged on or between at least two stacked dielectric layers (5, 6) with a layer of tunable dielectric material (12) sandwiched between the at least two stacked dielectric layers (5, 6), with each tunable radio frequency transmission element (4) comprising at least one transmission line (3) with tunable capabilities that is electrically conductively connected with bias lines (10, 11) to at least one biasing circuit, **characterized in that** at least one dielectric layer (10, 11) is made from an optically transparent material, **in that** at least an overlapping section of the bias lines (10, 11) of each of the tunable radio frequency transmission elements (4) is made from an optically transparent and electroconductive material, and **in that** the tunable dielectric material (12) is selected from a group of materials that affect the transmission or reflection of light that illuminates the tunable dielectric material (12) depending on the respective tuning state of the tunable dielectric material, the method comprising a testing step during which the layer arrangement (1) is illuminated by light, during which a predetermined electric bias potential is applied to at least some of the tunable radio frequency transmission elements (4), and during which the light emission from the layer arrangement (1) depending on the applied bias potential is detected, and whereby the detected light emission is compared with a light emission that is expected for bias lines (10, 11) in proper working conditions.

2. Method according to claim 1, **characterized in that** the light emission is detected by a light recording device (15) and subsequently evaluated by an evaluation device.

3. Method according to claim 1 or 2, **characterized in that** all of the at least two stacked dielectric layers (5, 6) are made from an optically transparent material, and **in that** during the testing step the layer arrangement (1) is illuminated from a first side of the layer arrangement (1) and the light transmitted through the layer arrangement (1) is detected at a second side of the layer arrangement (1) that is opposing the first side.

4. Method according to one or more of the preceding claims, **characterized in that** during the testing step an identical bias potential is applied to the at least some of the tunable radio frequency transmission elements (4).

5. Method according to one or more of the preceding claims, **characterized in that** the intensity of the detected light emission is measured.

6. Method according to one or more of the preceding claims, **characterized in that** during the testing step the predetermined bias potential is applied to the at least some of the tunable radio frequency transmission elements (4) at the same time.

7. Method according to one of the preceding claims 1 to 5, **characterized in that** during the testing step the predetermined bias potential is applied to the at least some of the tunable radio frequency transmission elements (4) in a predetermined sequence one after another.

8. Method according to one or more of the preceding claims, **characterized in that** during the testing step a time difference between the application of a variation of the bias potential to a tunable radio frequency transmission element (4) and the resulting variation of the light emission is detected.

9. Method according to one or more of the preceding claims, **characterized in that** at least a section of the transmission line (3) of at least some of the tunable radio frequency transmission elements (4) is made from an optically transparent material, and **in that** during the testing step the light emission from this section of the transmission line (3) of at least some of the tunable radio frequency transmission elements (4) is detected.

10. Layer arrangement (1) for use within a phased array antenna, whereby the layer arrangement (1) comprises a number of tunable radio frequency transmission elements (4) that are arranged on or between at least two stacked dielectric layers (5, 6) with a layer of tunable dielectric material (12) sandwiched between the at least two stacked dielectric layers (5, 6), with each tunable radio frequency transmission element (4) comprising at least one transmission line (3) with tunable capabilities that is electrically conductively connected with bias lines (10, 11) to at least one biasing circuit, **characterized in that** at least one dielectric layer (5, 6) is made from an optically transparent material, **in that** at least a part of the bias lines (10, 11) of each of the tunable radio frequency transmission elements (4) is made from an optically transparent and electroconductive material, and **in that** the tunable dielectric material (12) is selected from a group of materials that affect the transmission or reflection of light that illuminates the tunable dielectric material (12) depending on the respective tuning state of the tunable dielectric material (12).

11. Layer arrangement (1) according to claim 10, **characterized in that** the overlapping section of the bias lines (10, 11) of each of the tunable radio frequency transmission elements (4) comprise a testing area (13) with a width of the testing area (13) larger than the width of the bias lines (10, 11) outside of the testing area (13).

12. Layer arrangement (1) according to claim 10 or claim 11, **characterized in that** at least a section of the transmission line (3) is made from an optically transparent material.

13. Layer arrangement (1) according to one of the claims 10 to 12, **characterized in that** the tunable radio frequency transmission elements (4) are phase shifting units or comprise one or more phase shifting units.
